(19) Europäisches Patentamt
European Patent Office
Office européen des brevets

(11) **EP 2 051 396 B1**

(12) **FASCICULE DE BREVET EUROPEEN**

(45) Date de publication et mention
de la délivrance du brevet:
**13.01.2016 Bulletin 2016/02**

(51) Int Cl.:
*H04B 3/56* *(2006.01)*   *H03H 7/42* *(2006.01)*
*H03H 7/06* *(2006.01)*

(21) Numéro de dépôt: **08166399.9**

(22) Date de dépôt: **10.10.2008**

(54) **Transmission par courants porteurs en ligne**

Online-Übertragung durch Trägerstrom

On-line transmission by carrier currents

(84) Etats contractants désignés:
**AT BE BG CH CY CZ DE DK EE ES FI FR GB GR
HR HU IE IS IT LI LT LU LV MC MT NL NO PL PT
RO SE SI SK TR**

(30) Priorité: **16.10.2007 FR 0758365**

(43) Date de publication de la demande:
**22.04.2009 Bulletin 2009/17**

(73) Titulaire: **Orange**
**75015 Paris (FR)**

(72) Inventeurs:
• **Roblot, Sandrine**
**22300, ROSPEZ (FR)**
• **Roblot, Christophe**
**22300, ROSPEZ (FR)**
• **Zeddam, Ahmed**
**22700, PERROS-GUIREC (FR)**

(56) Documents cités:
**WO-A-96/07245     GB-A- 2 154 834
US-A- 3 846 638     US-A1- 2003 095 036**

**Description**

## 1. Domaine de l'invention

Le domaine de l'invention est celui de la transmission d'informations par Courants Porteurs en Ligne (CPL, encore appelés PLT pour "Power Line Transmission").

Elle s'applique notamment, mais non exclusivement, à la transmission d'informations multimédia (voix et/ou données) à haut débit par le réseau d'énergie électrique au sein d'une habitation (application "indoor" des systèmes de transmission CPL).

## 2. Art antérieur et ses inconvénients

On rappelle que la technique de transmission par Courants Porteurs en Ligne utilise le réseau de distribution électrique comme infrastructure de communication pour transporter l'information numérique. Elle consiste à superposer au courant électrique à basse fréquence (typiquement, en Europe, 50 Hz, ou 60 Hz aux Etats-Unis) un signal à plus haute fréquence et de faible énergie. Ce signal à haute fréquence est propagé le long des lignes d'une installation électrique (par exemple le réseau électrique d'une habitation). Lorsqu'il est reçu par un équipement de réception CPL (encore couramment appelé modem) du réseau électrique considéré, ce signal analogique peut être décodé, sous forme d'un flux de bits, afin que les données qu'il véhicule soient restituées sur un dispositif adéquat (par exemple un ordinateur). Un tel modem comprend également des moyens de traitement d'informations de redondance (de type codes correcteurs d'erreur) utilisées pour rendre le signal plus robuste vis-à-vis du bruit et des atténuations.

Cette technologie peut ainsi être utilisée pour la réalisation d'un réseau informatique interne à un bâtiment (immeuble, école, etc.). On parle d'application "indoor".

Une transmission par CPL peut se faire à haut ou à bas débit. Les transmissions CPL à haut débit utilisent des modulations multiporteuses de type OFDM (pour "Orthogonal Frequency Division Multiplexing", modulation par répartition en fréquences orthogonales) dans une bande de fréquence généralement comprise entre 1,6 et 30 MHz. Les transmissions CPL à bas débit présentent quant à elles des fréquences généralement comprises entre 3 et 148kHz.

Le réseau électrique d'une installation domestique (ou plus généralement "indoor") constitue, pour les Courants Porteurs en Ligne, un support de transmission particulièrement difficile. En effet, les inventeurs de la présente demande de brevet ont constaté que la fonction de transfert du canal de transmission constitué par le câble électrique situé entre deux prises de courant d'une installation électrique variait de manière relativement imprévisible. Ainsi, ce canal de transmission présente une réponse en amplitude et en phase qui varie très fortement en fonction de la fréquence. Des mesures effectuées ont mis en évidence une oscillation de la réponse en amplitude entre 0 et -80dB.

Ces fortes variations de la fonction de transfert du canal de transmission sont dues notamment au comportement quasi-aléatoire des différentes charges de l'installation électrique considérée, par exemple des appareils électroménagers branchés sur le réseau électrique de l'habitation. La réponse du canal de transmission s'avère également variable dans le temps, en fonction de l'état de fonctionnement de ces appareils électriques (mode veille ou en fonctionnement), et même de la présence ou absence d'un appareil électrique sur une prise de courant donnée.

En conséquence de ces fortes variations de la fonction de transfert du canal de transmission, certaines bandes fréquentielles présentent de profonds évanouissements, variables dans le temps, qui ne permettent pas de garantir une transmission des signaux à haut débit sans erreur.

On connaît plusieurs techniques permettant de compenser les difficultés de transmission dues aux imperfections de la fonction de transfert d'un canal. Ces techniques sont en grande majorité de type numérique, et reposent généralement sur une compensation des pertes occasionnées par les imperfections du canal de transmission.

Une première de ces techniques consiste à réaliser un étalement de spectre, pour transmettre le signal sur une bande de fréquences plus large que l'ensemble des fréquences qui le compose, et ainsi réduire l'effet néfaste de certains évanouissements en fréquence du canal de transmission. En réception, le signal original est récupéré par corrélation. Cependant, un inconvénient de cette technique d'étalement de spectre est qu'elle n'est efficace que pour les transmissions à bas débit, et ne peut donc s'appliquer à la transmission de signaux à haut débit par Courants Porteurs en Ligne.

Une deuxième technique connue consiste à réaliser une égalisation, au moyen d'un filtre adapté, pour résoudre la distorsion d'amplitude et de phase provoquée par le canal. Cependant, un inconvénient de cette technique d'égalisation est qu'elle est particulièrement complexe à mettre en oeuvre.

On connaît également du document de brevet WO0169812 intitulé "Powerline Communication System, Powerline Communication Transmission Network and Powerline Communication Device" un dispositif de communication de type PLC comprenant une impédance adaptative, dont la valeur s'adapte automatiquement aux changements de conditions de transmission. Une telle impédance adaptative permet de réduire les effets néfastes des évanouissements en fréquence dans un réseau de transmission CPL, soit par transformation d'impédance, soit en déplaçant de tels évanouissements dans des bandes de fréquence qui ne sont pas utilisées pour la transmission de données.

Un inconvénient de cette technique est qu'elle nécessite d'évaluer en temps réel les conditions de transmission sur le réseau électrique, afin d'adapter l'impédance du dispositif. Une telle évaluation se fait au moyen d'un traitement logiciel embarqué dans le modem CPL. Une telle technique est de type corrective, et n'empêche pas l'introduction de perturbations dans le réseau électrique.

US 2003/0095036 décrit un système de communication CPL où le filtrage et l'adaptation s'effectue sur la ligne à basse fréquence.

Ces différentes méthodes reposant sur des traitements numériques des signaux effectués dans le modem CPL, elles nécessitent toutes une intervention logicielle au niveau de cet équipement, ce qui peut s'avérer problématique pour les modems CPL déjà installés au sein d'un réseau électrique, sur lesquels une mise à jour logicielle peut être difficile à réaliser.

Il existe donc un besoin d'une technique qui permette, non pas de compenser les pertes occasionnées par les imperfections du canal de transmission CPL dans une installation électrique, mais d'éviter, ou à tout le moins réduire, l'apparition de ces imperfections. Plus précisément, il existe un besoin d'une technique qui permette d'empêcher les perturbations provenant de l'état de branchement des prises de courant (appareil en marche, appareil en veille, absence d'appareil) de dégrader les caractéristiques de transmission du canal constitué par le réseau électrique domestique.

### 3. Exposé de l'invention

L'invention répond à ce besoin en proposant un dispositif comprenant les caractéristiques de la revendication 1.

L'invention repose donc sur une approche nouvelle et inventive du traitement de la problématique de la forte variabilité de la fonction de transfert du canal de transmission constitué par le réseau électrique d'un système de transmission par CPL. En effet, alors que toutes les techniques connues jusqu'à ce jour reposent sur une compensation des pertes occasionnées par la présence d'évanouissements en fréquence dans cette fonction de transfert, l'invention propose au contraire d'éviter l'apparition de ces évanouissements en fréquence.

Pour ce faire, l'invention repose sur une approche physique du problème, consistant à réaliser une adaptation d'impédance dans la bande de fréquence des signaux CPL, permettant d'empêcher la réflexion de ces signaux. Cette adaptation est caractéristique d'un type de câble électrique (plus précisément des conducteurs (par exemple phase et neutre, ou terre, phase et neutre) qui le constituent), de sorte que le même dispositif selon l'invention peut être utilisé dans toute installation électrique utilisant ce type de câble. Contrairement aux méthodes de l'art antérieur, et notamment à la technique du document WO0169812, la technique de l'invention ne tient donc pas compte des caractéristiques de la transmission des signaux à haute fréquence, mais des caractéristiques de l'installation électrique considérée.

Notamment, on tient compte des paramètres linéiques des câbles du réseau, tels que l'inductance linéique et la capacité linéique de ces câbles.

La présence du dispositif de l'invention au sein d'une installation électrique permet donc d'empêcher l'introduction de perturbations dans la fonction de transfert du canal de transmission, liées à la présence ou absence de certains équipements électriques (sèche-cheveux, modem, lampe, ordinateur, etc.) sur les prises de courant de l'installation, ainsi que sur leur état de fonctionnement (marche ou veille). En d'autres termes, le dispositif de l'invention permet de garantir une stabilité du canal de transmission des signaux CPL, et, en conséquence, d'éviter les erreurs de transmission et d'améliorer la qualité de service.

La mise en oeuvre de l'invention ne nécessite aucune intervention logicielle au niveau des modem CPL, et peut être réalisée en complément de toute autre méthode numérique et/ou logicielle de traitement du signal.

En outre, les filtres permettent de bloquer les basses fréquences du signal d'alimentation électrique, et de ne réaliser l'adaptation d'impédance que pour les fréquences d'utilisation des systèmes CPL.

Ceci s'avère particulièrement important dans le mode de réalisation de l'invention dans lequel l'adaptation d'impédance est réalisée au moyen de résistances. En effet, à basse fréquence (par exemple 50 Hz), la consommation en énergie liée à la présence d'une résistance entre la phase et le neutre pourrait s'avérer problématique pour:

- le dégagement de chaleur occasionné (effet "radiateur");
- la surconsommation engendrée pour le client de l'installation électrique;
- la perte d'énergie qui ne serait plus disponible pour les équipements électriques à connecter au réseau;
- la destruction du dispositif de l'invention, due au grillage des résistances.

La présence de tels filtres passe-haut de part et d'autre des moyens d'adaptation d'impédance permettent de bloquer le signal d'alimentation à basse fréquence tant en entrée qu'en sortie du dispositif de l'invention, de façon à éviter que ce signal basse fréquence ne traverse les moyens d'adaptation.

Selon un mode de réalisation de l'invention, les moyens d'adaptation d'impédance comprennent au moins un composant passif appartenant au groupe comprenant:

- une résistance;
- une inductance;
- une capacité.

Le dispositif de l'invention peut ainsi être réalisé sous la forme d'un quadripôle à base de composants passifs R, L, C. Les valeurs de ces composants sont fixes, et choisies en fonction des caractéristiques du câble électrique utilisé dans l'installation considérée. Aucune intervention logicielle et/ou automatique n'est nécessaire pour modifier ces valeurs en fonction des conditions courantes de transmission des signaux dans le réseau électrique.

De manière avantageuse, la gaine comprenant trois conducteurs respectivement appelés terre, phase et neutre, les moyens d'adaptation d'impédance comprennent trois résistances destinées à être respectivement connectées:

- entre la terre et le neutre;
- entre la terre et la phase;
- entre la phase et le neutre.

Ainsi, pour une installation comprenant classiquement un fil de terre, un fil de phase et un fil de neutre dans un réseau électrique à 50 Hz par exemple, les moyens d'adaptation de l'invention se présentent sous la forme d'un réseau en $\pi$, qui permet de réaliser une adaptation complète de la ligne de transmission.

Pour une installation ne comprenant pas de fil de terre, on peut envisager d'utiliser le même dispositif, dans lequel les bornes des résistances destinées à y être connectées seraient laissées "en l'air".

Dans un mode de réalisation de l'invention, un tel dispositif comprend également des moyens de transmission de ladite composante de signal à basse fréquence disposés en parallèle desdits moyens d'adaptation d'impédance. Par exemple, le dispositif de l'invention comprend un filtre passe-bas, permettant de bloquer le signal CPL à haute fréquence, et de laisser passer le signal d'alimentation à basse fréquence sans adaptation d'impédance, directement en sortie du dispositif.

Selon un mode de réalisation de l'invention, un tel dispositif comprend des premiers moyens de connexion à une prise d'accès au réseau électrique et des seconds moyens de connexion à un équipement électrique apte à être branché sur ladite prise.

Le dispositif peut ainsi se présenter sous la forme d'un adaptateur de prise, comprenant par exemple, comme premiers moyens de connexion, une prise mâle (par exemple sous la forme de deux fiches), destinée à être enfoncée dans la prise électrique, et, comme seconds moyens de connexion, une prise femelle (par exemple sous la forme de deux douilles) destinée à recevoir les fiches mâles d'un équipement électrique (sèche-cheveux, lampe, téléviseur, modem CPL, etc.) à connecter au secteur.

On adapte ainsi en impédance les prises de courant de l'installation électrique considérée, afin d'empêcher la réflexion des signaux correspondant aux fréquences de transmission de données CPL à haute fréquence lorsque ceux-ci arrivent sur la prise. En effet, l'impédance présentée par une prise laissée en circuit ouvert ou sur laquelle un équipement électrique est branché diffère de celle du réseau électrique. La réflexion à éviter est ainsi celle des signaux CPL, mais également celle de perturbations à haute fréquence introduites sur le réseau par les équipements électriques.

Le dispositif de l'invention constitue donc une interface entre le réseau d'énergie et les équipements électriques qui y sont connectés.

Selon un autre mode de réalisation, l'invention concerne une prise d'accès à un réseau électrique (par exemple une prise de courant), comprenant un dispositif tel que décrit précédemment.

Ainsi, le dispositif de l'invention est intégré directement au sein des prises d'accès à une installation électrique. Sa présence est donc transparente pour l'utilisateur de l'installation. En outre, on empêche ainsi les perturbations conduites par les appareils électriques branchés sur le secteur de pénétrer dans le réseau. On peut envisager que toutes, ou seulement certaines, des prises électriques de l'installation considérée intègrent un dispositif conforme à l'invention.

Selon encore un autre mode de réalisation, éventuellement complémentaire du précédent, l'invention concerne un équipement comprenant des moyens de connexion à un réseau électrique, qui intègre un dispositif tel que décrit précédemment. Ainsi, le dispositif de l'invention n'est plus disposé dans les prises électriques, ou sous forme d'adaptateur de prise, mais est directement intégré dans tout équipement électrique susceptible d'être branché sur le secteur. Il peut s'agir d'un équipement domestique, comme un appareil électroménager de type aspirateur ou sèche-cheveux, ou encore d'un équipement de communication, et notamment d'un modem CPL.

L'invention concerne enfin un système de transmission de données par courant porteur en ligne, comprenant au moins un réseau électrique présentant une pluralité de prises d'accès, aptes à coopérer avec au moins un équipement comprenant des moyens de connexion au réseau, au moins un équipement émetteur de signal de données à haute fréquence, et au moins un équipement récepteur de signal de données à haute fréquence.

Selon l'invention, dans un tel système, chaque prise d'accès au réseau électrique situé entre l'équipement émetteur et l'équipement récepteur comprend un dispositif tel que décrit précédemment.

Ainsi, chaque prise de courant de l'installation électrique située entre les deux modem CPL du système de transmission CPL est équipée d'un dispositif selon l'invention. Un tel dispositif peut être présent au niveau de chaque prise sous forme d'adaptateur de prise, ou sous forme intégrée, soit directement dans la prise, soit dans l'équipement électrique qui y est connecté.

En installant le dispositif de l'invention sur toutes les prises situées entre l'émetteur et le récepteur des signaux à haut débit, on minimise ainsi le risque d'introduction de perturbations sur le réseau électrique servant de transmission aux signaux CPL. On peut bien sûr également envisager que toutes les prises de l'installation électrique, et non seulement celles situées entre les deux modems, soient équipées d'un dispositif selon l'invention.

## 4. Liste des figures

D'autres avantages et caractéristiques de l'invention apparaîtront plus clairement à la lecture de la description suivante d'un mode de réalisation particulier de l'invention, donné à titre de simple exemple illustratif et non limitatif, et des dessins annexés, parmi lesquels :

- la figure 1 illustre un exemple de dispositif selon l'invention pour un câble électrique comprenant trois conducteurs;
- la figure 2 présente le dispositif de la figure 1 intégré dans une prise d'accès à une installation électrique;
- la figure 3 présente le dispositif de la figure 1 sous la forme d'un adaptateur de prise de courant murale;
- la figure 4 illustre un exemple de réseau de distribution électrique support d'un système de transmission par CPL selon l'invention;
- la figure 5 présente un schéma fonctionnel d'un dispositif conforme à l'invention;
- les figures 6A et 6B illustrent un premier exemple d'implémentation du dispositif de la figure 5;
- la figure 7 présente un élément infinitésimal d'une ligne à un conducteur au-dessus d'un plan de masse, dans le cadre d'un rappel sur la théorie des lignes de transmission;
- la figure 8 propose un deuxième exemple d'implémentation du dispositif de la figure 5;
- la figure 9 propose un troisième exemple d'implémentation du dispositif de la figure 5.

## 5. Description d'un mode de réalisation particulier de l'invention

Le principe général de l'invention repose sur la mise en oeuvre, dans un système de transmission par Courants Porteurs en Ligne, d'un dispositif physique permettant d'adapter au moins certaines terminaisons du réseau (i.e. les prises de courant) sur l'impédance caractéristique du réseau électrique domestique, de façon à empêcher certaines perturbations de pénétrer sur ce réseau.

On s'attache par la suite à décrire un mode de réalisation particulier de l'invention, dans le cadre d'une habitation équipée d'un système de transmission par CPL.

On rappelle que dans les systèmes CPL, l'atténuation des signaux est un problème récurrent, alors que les distances mises en jeu sont courtes (au maximum quelques centaines de mètres). Ceci provient notamment du nombre important de dérivations, branches secondaires connectées au chemin principal, se terminant en circuit ouvert ou sur des équipements ne présentant pas une impédance correspondant à celle de la ligne.

Ainsi, il a été constaté que le canal de propagation subissait une atténuation très importante dans les habitations comportant un nombre élevé de prises électriques.

De plus, l'utilisation d'appareils électroménagers augmente le niveau de bruit sur le réseau électrique domestique selon leur état de fonctionnement (marche / arrêt). A titre informatif, la variation du niveau de bruit peut atteindre 30 dB pour les lampes à basse consommation.

Ainsi, la connexion d'équipements électriques engendre d'importantes fluctuations de la fonction de transfert du canal de transmission CPL et des évanouissements conséquents à certaines fréquences, dépendantes du type d'équipement connecté.

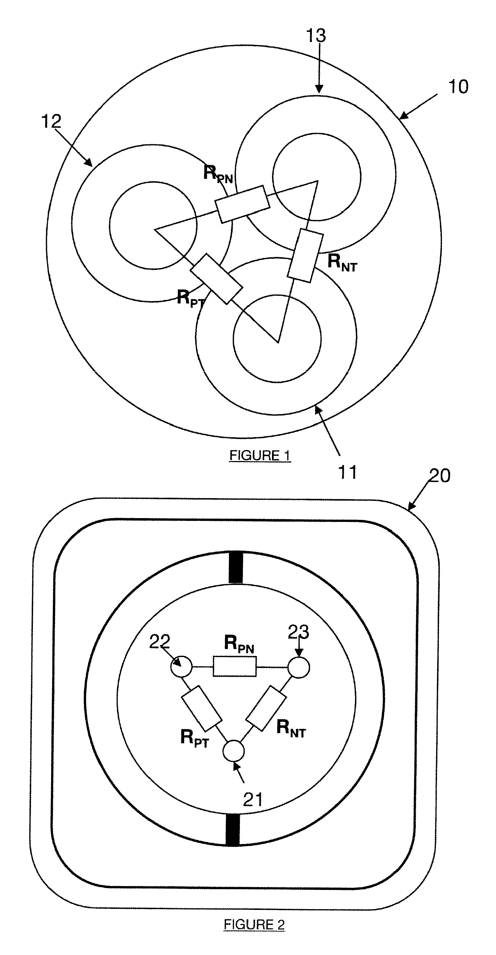

L'invention remédie à ce problème en proposant un dispositif, illustré sous une forme simplifiée en figure 1, qui permet d'empêcher l'introduction de perturbations sur le réseau électrique.

On considère un câble électrique comprenant une gaine 10 et trois conducteurs, correspondant respectivement à un fil de terre 11, à un fil de phase 12 et à un fil de neutre 13. Le dispositif de l'invention se présente sous la forme d'un réseau en $\pi$ comprenant trois résistances:

- $R_{PN}$ connectée entre la phase 12 et le neutre 13;
- $R_{NT}$ connectée entre la terre 11 et le neutre 13;
- $R_{PT}$ connectée entre la phase 12 et la terre 11.

Les valeurs des résistances $R_{PN}$, $R_{NT}$, $R_{PT}$ sont déterminées en fonction des caractéristiques électriques des conducteurs 11 à 13. Elles permettent de réaliser une adaptation d'impédance de la ligne de transmission constituée par le câble électrique 10, et d'empêcher ainsi la réflexion des signaux CPL à haute fréquence.

Ce dispositif peut être intégré dans une prise électrique constituant une terminaison du réseau de distribution électrique considéré, comme illustré sur la figure 2.

Une telle prise de courant 20 comprend deux orifices 22 et 23 respectivement connectés au fil de phase 12 et au fil de neutre 13 du câble électrique de la figure 1. Ces deux orifices sont destinés à recevoir les broches d'une fiche mâle d'un équipement électrique à brancher sur le secteur.

Elle comprend également une broche 21, connectée au fil de terre 11 de la figure 1. Cette broche 21 est destinée à coopérer avec la partie femelle d'une fiche de connexion d'un équipement électrique. Elle peut aussi rester "en l'air", pour un équipement qui n'a pas besoin d'être connecté à la terre (par exemple, une lampe).

Les résistances $R_{PN}$, $R_{NT}$, $R_{PT}$ sont intégrées dans la prise 20, en arrière des orifices 22 et 23 et de la broche 21.

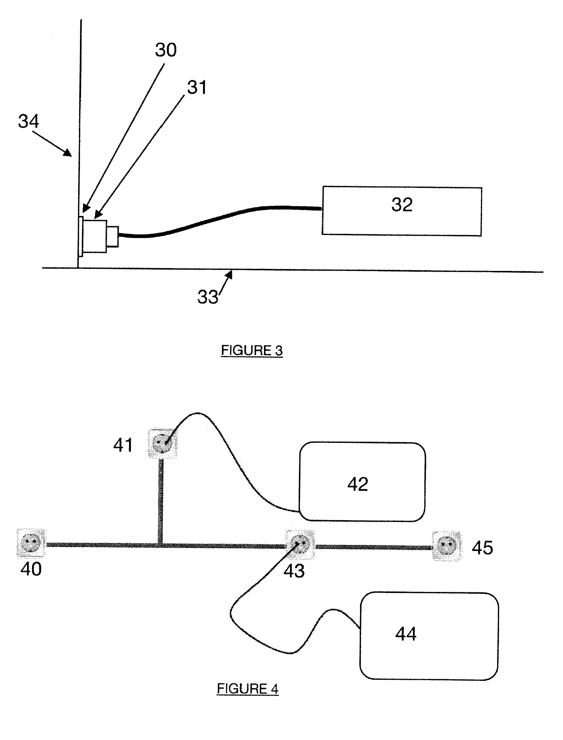

Le dispositif de la figure 1 peut également se présenter sous la forme d'un adaptateur de prise, comme illustré sur la figure 3. Dans une habitation dont le sol est référencé 33, une prise de courant 30 est encastrée dans le mur 34. Le dispositif de l'invention se présente, dans ce mode de réalisation, sous la forme d'un adaptateur de prise 31, qui comprend au moins deux fiches mâles destinées à coopérer avec les deux orifices d'une prise de courant 30, pour brancher le dispositif sur la prise électrique, et au moins deux fiches femelles destinées à coopérer avec les broches de connexion d'un équipement ou appareil électrique 32 à brancher sur le réseau d'énergie.

Plus précisément, sur la face de l'adaptateur 31 situé côté prise de courant 30, l'adaptateur comprend deux fiches mâles pour connexion à la phase et au neutre de la prise de courant 30 et une douille femelle pour connexion à la terre de la prise de courant 30. Côté appareil électrique 32, l'adaptateur comprend deux douilles femelles et une fiche mâle.

Dans le cas d'un réseau électrique ne comprenant pas de fil de terre, le connecteur correspondant de l'adaptateur peut être laisse "en l'air".

On présente désormais, en relation avec la figure 4, un exemple de réseau électrique domestique servant de support de transmission à un système de transmission par Courants Porteurs en Ligne. On considère ici que seule la portion du réseau électrique illustrée en figure 4 sert de support à la transmission par CPL, le reste du réseau électrique n'étant pas représenté sur la figure 4.

Une première prise de courant 40 constitue le point d'entrée du système de transmission CPL. Un modem CPL jouant le rôle d'émetteur de signaux à haute fréquence, non représenté sur la figure 4, est branché sur cette prise de courant 40. A l'autre extrémité du système, une prise de courant 45 constitue le point de sortie du système de transmission CPL et est destinée à recevoir un deuxième modem CPL jouant le rôle de récepteur de signaux à haute fréquence, non représenté sur la figure 4.

Entre ces deux prises de courant 40 d'entrée et 45 de sortie, deux prises de courant 41 et 43 sont respectivement connectées à deux appareils électriques 42 et 44, par exemple une lampe et un téléviseur. Selon l'état de fonctionnement de ces différents appareils, des perturbations peuvent apparaître dans la fonction de transfert du réseau électrique de la figure 4, comme exposé précédemment.

Pour éviter l'introduction de ces perturbations dans ce réseau, un dispositif du type de celui de la figure 1 est connecté à chacune des prises de courant 40, 41, 43 et 45. Par exemple, ce dispositif est intégré directement dans les modems CPL branchés sur les prises 40 et 45; il est présent sous forme d'adaptateur de prise au niveau de la prise 41 (voir figure 3), et il est intégré directement dans la prise de courant 43 (voir figure 2).

En adaptant chacune des prises de la figure 4, on optimise la stabilité de la fonction de transfert du canal de transmission du système CPL.

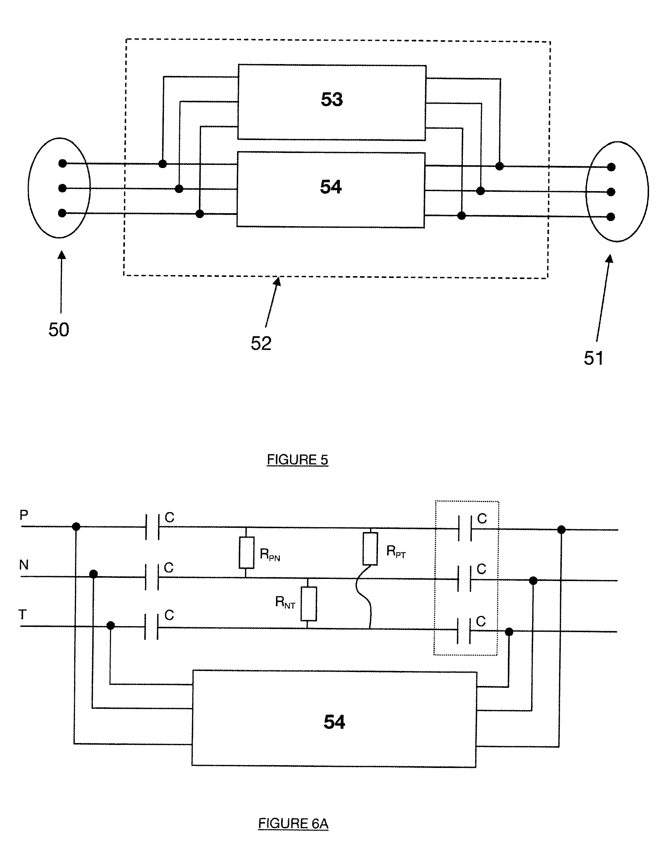

On présente désormais, sous forme du schéma fonctionnel de la figure 5, un mode de réalisation plus détaillé du dispositif de la figure 1.

On se place dans la cas particulier d'un réseau de distribution électrique domestique à 50Hz.

L'utilisation des seules résistances $R_{PN}$, $R_{NT}$, $R_{PT}$ pour réaliser l'adaptation d'impédance, peut s'avérer problématique à la fréquence du 50 Hz.

En effet, si les résistances $R_{PN}$ et $R_{PT}$ ne sont pas de même valeur, un courant électrique peut circuler entre neutre et terre, et provoquer ainsi le déclenchement du disjoncteur différentiel.

En outre, pour une valeur de la résistance $R_{PN}$ de l'ordre de 140 Ω environ, à 50 Hz, la consommation en énergie devient très importante (environ 345,7 W). En plus de l'effet "radiateur" et de la surconsommation engendrée, la résistance elle-même risque d'être sévèrement endommagée, ce type de résistance étant généralement conçu pour supporter une puissance maximale de 1 W environ. De plus, cette énergie perdue ne serait plus disponible pour les appareils électriques à connecter au réseau.

Dans un mode de réalisation amélioré, le dispositif de la figure 5 est donc conçu de façon à n'appliquer l'adaptation d'impédance que pour les fréquences d'utilisation des systèmes CPL.

Pour ce faire, il se présente sous la forme d'une interface 52 entre une prise électrique (murale ou au sol) 50 et un équipement électrique destiné à être branché sur une prise 51. Cette prise 51 est la prise électrique telle qu'elle se présente à l'utilisateur, pour connecter des appareils sur secteur fonctionnant à partir d'une alimentation électrique à 50 Hz, ou des équipements de communication CPL, qui ont besoin de recevoir, d'une part, l'alimentation électrique à 50Hz, et d'autre part, un signal haute fréquence adapté dans une bande de fréquences sensiblement comprise entre 1,6 MHz et 30 MHz (par souci de simplification, on se restreint dans ce mode de réalisation aux transmissions CPL à haut débit, bien que l'invention soit également applicable pour les transmissions CPL à bas débit). La prise 51 fait partie du dispositif de l'invention.

L'interface 52 comprend:

- des moyens 53 destinés à réaliser l'adaptation d'impédance dans la bande de fréquence des signaux à haute fréquence, par exemple au-dessus du MHz;
- des moyens 54 assurant le passage direct du 50 Hz au travers du dispositif sans adaptation d'impédance.

Ainsi, les appareils électriques (par exemple électroménagers) qui ont besoin de recevoir la composante du signal à 50Hz pour leur alimentation ne sont pas perturbés par la présence des moyens 53 d'adaptation d'impédance. Les appareils de communication CPL qui ont quant à eux besoin de recevoir la composante d'alimentation à 50Hz et le signal CPL à haute fréquence bénéficient avantageusement de la présence des moyens 53 d'adaptation d'impédance.

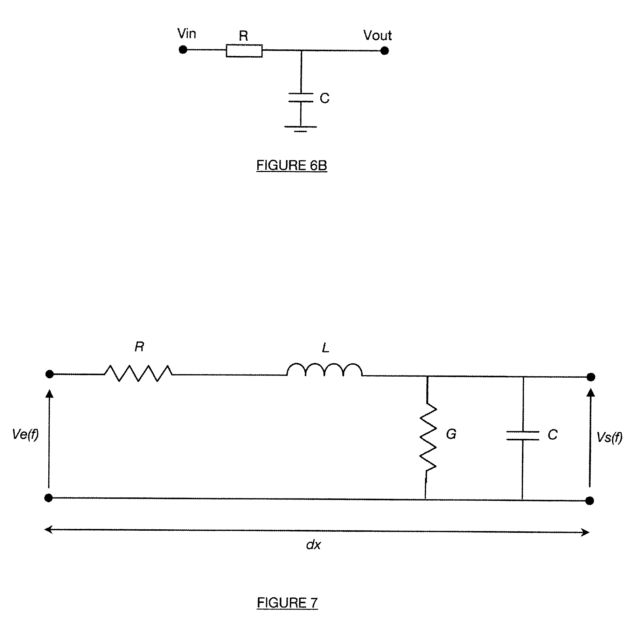

Les figures 6A et 6B illustrent un exemple pratique de réalisation des moyens référencés 53 et 54.

On considère les trois conducteurs P, N et T correspondant respectivement aux fils de phase, de neutre et de terre. Les moyens d'adaptation d'impédance 53 comprennent un ensemble de six capacités C, et de trois résistances $R_{PN}$, $R_{NT}$, $R_{PT}$. On choisit par exemple: $R_{PN}$ = 140 Ω, $R_{PT}$ = 120 Ω, $R_{NT}$ = 120 Ω.

Pour fixer les valeurs de ces résistances $R_{PN}$, $R_{NT}$, $R_{PT}$, on tient compte des paramètres linéiques des câbles du réseau. Dans le mode de réalisation présenté ici, ces paramètres linéiques ont été mesurés pour un câble électrique de type 3G2.5. On rappelle que la référence 3G2.5 désigne un câble électrique constitué de « 3 fils de section 2.5mm$^2$ ». La lettre G indique que le câble électrique comprend également un conducteur de protection, généralement de couleur vert/jaune. Cette désignation est normalisée par le CENELEC, à savoir le Comité Européen de la Normalisation Electrotechnique. Plus précisément, le câble électrique considéré dans le mode de réalisation décrit ici est de type H07RN-F 3G2,5, qui est utilisé dans l'industrie pour la réalisation de raccordements d'équipements.

Les valeurs des paramètres linéiques de ce câble électrique sont données ci-dessous, sous forme matricielle, pour l'inductance linéique L (en μH/m) et la capacité linéique C (en pF/m):

$$[L] = \begin{pmatrix} 1.6473 & 1.4244 & 1.4276 \\ 1.4244 & 1.6512 & 1.4165 \\ 1.4276 & 1.4165 & 1.6512 \end{pmatrix}$$

$$[C] = \begin{pmatrix} 80.3732 & -37.4014 & -37.4014 \\ -37.4014 & 81.1690 & -38.9930 \\ -37.4014 & -38.9930 & 80.3732 \end{pmatrix}$$

On notera que les matrices [L] et [C] ci-dessus sont de dimension 3 x 3 puisque le support considéré est composé de trois conducteurs (Phase, Neutre et Terre). Les éléments de la diagonale correspondent aux termes propres des conducteurs alors que les termes hors de la diagonale correspondent aux termes mutuels entre les conducteurs. On comprend donc que ces matrices sont symétriques.

On rappelle que les paramètres linéiques caractérisent électriquement les supports de propagation; on parle classiquement des paramètres RLCG, où:

- le paramètre R (Ω/m) correspond aux pertes dues à la chaleur dissipée dans les conducteurs;
- le paramètre L (H/m) correspond aux flux magnétiques entre les conducteurs;
- le paramètre C (F/m) correspond à la capacité entre le diélectrique et les conducteurs;
- le paramètre G (S/m) correspond aux pertes dans le diélectrique.

Les paramètres L et C peuvent être mesurés sur un banc de mesure dédié. Les pertes R sont mesurées par l'atténuation subie par les signaux lors de la transmission. Le paramètre G n'intervient que dans le cas de pertes constantes. En règle générale, les pertes dépendent de la fréquence. Dans ce cas, quatre paramètres doivent être mesurés pour caractériser les pertes R :

$$R(f) = \sqrt[4]{R_0 + a \cdot f^2 + b \cdot f^4 + c \cdot f^6}$$

Dans le cas du câble 3G2.5 considéré ici, ces quantités valent :

$R_0 = 10.10^{-3}$
$a = 3,8.10^{17}$
$b = 5,22.10^{-31}$
$c = 4,77.10^{-47}$

La connaissance des paramètres linéiques L, C et des pertes R(f) caractérise complètement le support de propagation étudié.

On rappelle que ces valeurs sont spécifiques à un type de câble, devant répondre à un gabarit fixé pour le constructeur. Ces valeurs peuvent donc être considérées comme génériques à toute la gamme de câbles 3G2.5.

Ces données sont ensuite traitées numériquement à partir de la théorie des lignes de transmission, selon la succession d'étapes ci-dessous :

- à partir des matrices [L] et [C], on calcule la matrice d'impédance caractéristique [$Z_c$] du câble électrique:

$$[Z_C] = \begin{pmatrix} 350.3 & 307.9 & 309.3 \\ 307.9 & 352.7 & 309.6 \\ 309.3 & 309.6 & 355.1 \end{pmatrix}$$

- par inversion matricielle, on détermine les éléments du réseau en π équivalent pour une ligne à trois conducteurs (puisque ce sont des matrices de dimensions 3 x 3) au-dessus d'un plan de référence.

Z1 = 906.3 Ω
Z2 = 963.5 Ω
Z3 = 105.3 Ω
Z12 = 137 Ω
Z13 = 135 Ω
Z23 = 140.4 Ω

- dans le cas présent, le conducteur de terre étant la référence, une simplification du réseau s'impose. On obtient les valeurs $R_{PN}$ = 140,4 Ω, $R_{NT}$ = 119,6 Ω, $R_{PT}$ = 122,6 Ω, que l'on simplifie en $R_{PN}$ = 140 Ω, $R_{NT}$ = 120 Ω, $R_{PT}$ = 120 Ω.

On rappelle, en relation avec la figure 7 que, selon la théorie des lignes de transmission, un tronçon infinitésimal de ligne de longueur *dx* est caractérisé par un quadripôle composé d'une résistance linéique *R*, d'une inductance linéique *L*, d'une conductance linéique *G* et d'une capacité linéique *C*.

Ces quatre composants, qualifiés de paramètres primaires et connus sous le terme de paramètres RLCG, dépendent en général de la fréquence mais sont indépendants de la position pour les lignes homogènes. Un tel quadripôle présente une tension d'entrée Ve(f) et une tension de sortie Vs(f).

Sur la figure 6A, l'ensemble constitué par une capacité C et une résistance R constitue un filtre passe-haut de fréquence de coupure $f_c = \dfrac{1}{2\pi RC}$ . La valeur de la capacité C détermine donc la fréquence de coupure du filtre. Par exemple, pour C=10 nF, on a une fréquence de coupure à environ 100 kHz, et pour C=100 nF, la coupure se produit environ à 10 kHz, compte tenu des valeurs de résistances choisies.

Les capacités situées en amont des résistances (à gauche des résistances sur la figure 6A) forment, avec les résistances, des premiers filtres passe-haut, destinés à sélectionner, au sein du signal électrique arrivant à la prise 50 par le biais du réseau électrique, la composante haute fréquence destinée à alimenter les moyens 53 d'adaptation d'impédance.

Les capacités situées en aval des résistances (à droite des résistances sur la figure 6A) forment, avec les résistances, des seconds filtres passe-haut, destinés à empêcher la composante de signal à 50 Hz en provenance de l'équipement électrique connecté à la prise 51 de se retrouver dans les moyens 53 d'adaptation d'impédance.

On notera par ailleurs que le choix des composants à utiliser doit également tenir compte de leur tension d'isolement. Ainsi, une tension d'isolement de 400 V pour les capacités C convient dans le cadre de l'invention. On rappelle en effet que le diélectrique d'un condensateur ne peut supporter une tension infinie. La tension maximum d'isolement est fonction de l'isolant choisi et de l'épaisseur du diélectrique. Au delà il peut y avoir percement du diélectrique et claquage du condensateur.

Le bloc référencé 54 constitue un filtre passe-bas destiné à laisser passer le 50 Hz au travers du dispositif de l'invention, sans qu'il subisse l'adaptation d'impédance. La figure 6B donne un exemple de réalisation de ce filtre passe-bas, sous la forme d'une résistance R et d'une capacité C, dont la fréquence de coupure vaut:

$f_c = \dfrac{1}{2\pi RC}$ . Il convient de déterminer les valeurs adéquates de R et de C, qui permettent une sélection efficace de la composante à 50 Hz, et n'induisent pas une trop forte consommation d'énergie.

Pour réduire la consommation d'énergie d'un tel filtre passe-bas, ce filtre doit présenter une résistance de faible valeur. On peut même envisager, dans un mode de réalisation particulier de l'invention, de n'utiliser qu'une capacité C.

Dans ce cas, la valeur de la capacité est conditionnée par la valeur de la fréquence de coupure. Pour $f_c$ = 100 kHz, on obtient une capacité de 1.6 μF. En outre, plus $f_c$ est faible, plus la capacité est élevée, et plus la taille du composant est importante. A titre d'exemple, une capacité de 1 μF sous 400V possède un diamètre de 1 cm pour une longueur de 3 à 4 cm.

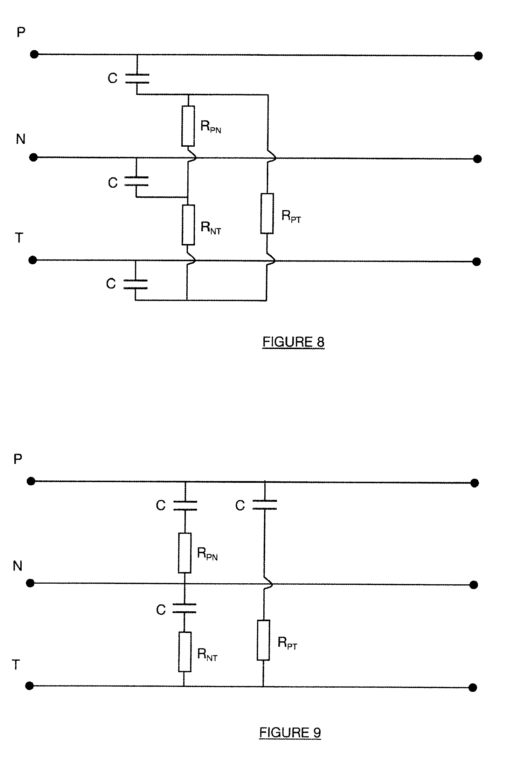

Les figures 8 et 9 présentent deux réalisations alternatives du dispositif.

Sur la figure 8, trois capacités C, connectées respectivement au fil de phase P, de neutre N et de terre T, empêchent la composante de signal à 50 Hz d'atteindre le réseau en π formé par les résistances $R_{PN}$, $R_{NT}$, $R_{PT}$. Ces capacités se comportent comme un circuit fermé aux hautes fréquences des signaux CPL, et comme un circuit ouvert pour les basses fréquences du signal d'alimentation à 50 Hz. Ainsi, la composante d'alimentation à 50 Hz passe directement en sortie du dispositif, alors que la composante à haute fréquence des signaux CPL traverse les capacités C et subit l'adaptation d'impédance du réseau de résistances $R_{PN}$, $R_{NT}$, $R_{PT}$.

Le mode de réalisation de la figure 9 constitue une solution quasi-équivalente, dans laquelle l'adaptation d'impédance est réalisée au moyen d'un réseau en π, dont chacune des trois branches est constituée d'une résistance et d'une capacité connectées en série.

En choisissant une valeur de capacité C=10 nF, et avec $R_{PN}$ = 140 Ω, $R_{PT}$ = 120 Ω, $R_{NT}$ = 120 Ω, le comportement du système est le suivant:

- aux basses fréquences, la capacité de 10 nF bloque le passage des ondes. La composante à 50 Hz traverse donc directement le dispositif, sans passer par le réseau d'adaptation d'impédance, via les conducteurs P, N et T;
- à 1 MHz, la contribution de la capacité en terme d'impédance est de l'ordre de 1 mΩ, ce qui s'avère négligeable par rapport aux 120 ou 140 Ω des résistances $R_{PN}$, $R_{NT}$, $R_{PT}$;
- à 10 MHz, cette contribution est d'environ 10 mΩ;
- à 100 MHz, cette contribution est d'environ 100 mΩ.

Dans ce mode de réalisation de la figure 9, l'adaptation d'impédance est donc réalisée aux hautes fréquences des signaux CPL, sans être perturbée par l'impédance de la capacité C.

L'invention trouve des applications dans tout système de transmission par CPL, qu'il s'agisse de haut ou de bas débit. On notera cependant que la problématique de qualité de service s'avère plus cruciale dans les systèmes de transmission à haut débit.

Ainsi, lorsque le système de transmission par CPL est utilisé pour la transmission d'images ou de vidéos, la mise en oeuvre de l'invention permet de s'affranchir des problèmes de gel d'image et de pixellisation dus aux imperfections du canal de transmission (par exemple en cas de branchement ou de mise en veille d'un équipement sur une des prises de courant du réseau électrique). L'invention permet également d'augmenter le débit minimum garanti dans un système de transmission par CPL.

**Revendications**

1. Dispositif de traitement d'un signal électrique comprenant au moins une composante de signal de données à haute fréquence et au moins une composante de signal d'alimentation à basse fréquence, ledit signal électrique étant véhiculé dans une gaine (10) comprenant au moins deux conducteurs (11-13) d'un réseau électrique,

   ledit dispositif comprenant des moyens d'adaptation d'impédance (53) dans une bande de fréquences de ladite composante de signal à haute fréquence, lesdits moyens d'adaptation d'impédance (53) étant déterminés en fonction d'au moins une caractéristique desdits conducteurs (11-13),

   ledit dispositif étant **caractérisé en ce qu'**il comprend en outre :

   au moins deux filtres passe-haut (C), disposés en amont desdits moyens d'adaptation (53) et respectivement connectés auxdits au moins deux conducteurs (11-13) de la gaine (10), et au moins deux filtres passe-haut (C), disposés en aval desdits moyens d'adaptation (53) et respectivement connectés à au moins deux conducteurs pour l'alimentation d'un équipement électrique, la fréquence de coupure desdits filtres passe-haut (C) étant comprise entre ladite basse fréquence et ladite haute fréquence ; et des moyens de transmission (54) de ladite composante de signal à basse fréquence disposés en parallèle desdits moyens d'adaptation d'impédance (53).

2. Dispositif selon la revendication 1, **caractérisé en ce que** lesdits moyens d'adaptation d'impédance (53) comprennent au moins un composant passif appartenant au groupe comprenant:

   - une résistance ($R_{PN}$, $R_{NT}$, $R_{PT}$);
   - une inductance;
   - une capacité (C).

3. Dispositif selon la revendication 1, **caractérisé en ce que** ladite gaine comprenant trois conducteurs respectivement appelés terre (11; T), phase (12; P) et neutre (13; N), lesdits moyens d'adaptation d'impédance (53) comprennent trois résistances ($R_{PN}$, $R_{NT}$, $R_{PT}$) destinées à être respectivement connectées:

   - entre ladite terre et ledit neutre;
   - entre ladite terre et ladite phase;
   - entre ladite phase et ledit neutre.

4. Dispositif selon la revendication 1, **caractérisé en ce qu'**il comprend des premiers moyens de connexion à une prise de courant (30) et des seconds moyens de connexion à un équipement électrique (32) apte à être branché sur ladite prise.

5. Prise (20) d'accès à un réseau électrique, **caractérisé en ce qu'**elle comprend un dispositif selon l'une quelconque des revendications 1 à 4.

6. Equipement comprenant des moyens de connexion à un réseau électrique, **caractérisé en ce qu'**il comprend un dispositif selon l'une quelconque des revendications 1 à 4.

7. Système de transmission de données par courant porteur en ligne,

   comprenant au moins un réseau électrique présentant une pluralité de prises d'accès, aptes à coopérer avec au moins un équipement comprenant des moyens de connexion audit réseau,

   au moins un équipement émetteur de signal de données à haute fréquence, et au moins un équipement récepteur de signal de données à haute fréquence, **caractérisé en ce que** chaque prise d'accès audit réseau électrique situé entre ledit équipement émetteur et ledit équipement récepteur comprend un dispositif selon l'une quelconque des revendications 1 à 4.

**Patentansprüche**

1. Vorrichtung zur Bearbeitung eines elektrischen Signals, umfassend mindestens eine Datensignalkomponente mit hoher Frequenz und mindestens eine Versorgungssignalkomponente mit niedriger Frequenz, wobei das elektrische Signal in einem Mantel (10) befördert wird, umfassend mindestens zwei Leiter (11-13) eines elektrischen Netzes,

   wobei die Vorrichtung Mitteln zur Impedanzanpassung (53) in einem Frequenzband der Hochfrequenzsignalkomponente umfasst, wobei die Impedanzanpassungsmittel (53) in Abhängigkeit von mindestens einem Merkmal der Leiter (11-13) bestimmt werden,

wobei die Vorrichtung **dadurch gekennzeichnet ist, dass** sie ferner umfasst:

mindestens zwei Hochpassfilter (C), die stromaufwärts zu den Anpassungsmitteln (53) angeordnet und jeweils an die mindestens zwei Leiter (11-13) des Mantels (10) angeschlossen sind, und mindestens zwei Hochpassfilter (C), die stromabwärts zu den Anpassungsmitteln (53) angeordnet und jeweils an mindestens zwei Leiter zur Versorgung einer elektrischen Ausrüstung angeschlossen sind, wobei die Grenzfrequenz der Hochpassfilter (C) zwischen der niedrigen Frequenz und der hohen Frequenz liegt; und Mittel zur Übertragung (54) der Niederfrequenzsignalkomponente, die parallel zu den Impedanzanpassungsmittel (53) angeordnet sind.

2. Vorrichtung nach Anspruch 1, **dadurch gekennzeichnet, dass** die Impedanzanpassungsmittel (53) mindestens eine passive Komponente umfassen, die der Gruppe angehört, umfassend:

- einen Widerstand ($R_{PN}$, $R_{NT}$, $R_{PT}$) ;
- eine Induktanz;
- eine Kapazität (C).

3. Vorrichtung nach Anspruch 1, **dadurch gekennzeichnet, dass**, da der Mantel drei Leiter, genannt Erde (11; T), Phase (12; P) bzw. Nullleiter (13; N), umfasst, die Impedanzanpassungsmittel (53) drei Widerstände ($R_{PN}$, $R_{NT}$, $R_{PT}$) umfassen, die dazu bestimmt sind, jeweils angeschlossen zu werden:

- zwischen der Erde und dem Nullleiter;
- zwischen der Erde und der Phase;
- zwischen der Phase und dem Nullleiter.

4. Vorrichtung nach Anspruch 1, **dadurch gekennzeichnet, dass** sie erste Anschlussmittel an einen Stromanschluss (30) und zweite Anschlussmittel an eine elektrische Ausrüstung (32), die geeignet ist, an den Anschluss angeschlossen zu werden, umfasst.

5. Anschluss (20) für den Zugang zu einem elektrischen Netz, **dadurch gekennzeichnet, dass** er eine Vorrichtung nach einem der Ansprüche 1 bis 4 umfasst.

6. Ausrüstung, umfassend Anschlussmittel an ein elektrisches Netz, **dadurch gekennzeichnet, dass** sie eine Vorrichtung nach einem der Ansprüche 1 bis 4 umfasst.

7. Datenübertragungssystem durch Online-Übertragung durch Trägerstrom, umfassend mindestens ein elektrisches Netz, das eine Vielzahl von Zugangsanschlüssen umfasst, die geeignet sind, mit mindestens einer Ausrüstung, umfassend Anschlussmittel an das Netz, zusammenzuwirken, mindestens eine Sendeausrüstung eines Hochfre-quenzdatensignals und mindestens eine Emp-fangsausrüstung eines Hochfrequenzdatensignals, **dadurch gekennzeichnet, dass** jeder Zugangsanschluss zu dem elektrischen Netz, der sich zwischen der Sendeausrüstung und der Empfangsausrüstung befindet, eine Vorrichtung nach einem der Ansprüche 1 bis 4 umfasst.

**Claims**

1. Device for processing an electrical signal comprising at least one high-frequency data signal component and at least one low-frequency power supply signal component, said electrical signal being conveyed in a sheath (10) comprising at least two conductors (11-13) of an electrical network, said device comprising impedance matching means (53) in a frequency band of said high-frequency signal component, said impedance matching means (53) being determined as a function of at least one characteristic of said conductors (11-13), said device being **characterized in that** it further comprises:

at least two high-pass filters (C), arranged upstream of said matching means (53) and respectively connected to said at least two conductors (11-13) of the sheath (10), and at least two high-pass filters (C), arranged downstream of said matching means (53) and respectively connected to at least two conductors for the power supply of an electrical equipment item, the cut-off frequency of said high-pass filters (C) lying between said low frequency and said high frequency; and means (54) for transmitting said low-frequency signal component arranged in parallel to said impedance matching means (53).

2. Device according to Claim 1, **characterized in that** said impedance matching means (53) comprise at least one passive component belonging to the group comprising:

- a resistor ($R_{PN}$, $R_{NT}$, $R_{PT}$);
- an inductor;
- a capacitor (C).

3. Device according to Claim 1, **characterized in that**, said sheath comprising three conductors respectively called earth (11; T), phase (12; P) and neutral (13; N), said impedance matching means (53) comprise three resistors ($R_{PN}$, $R_{NT}$, $R_{PT}$) intended to be respectively connected:

- between said earth and said neutral;
- between said earth and said phase;
- between said phase and said neutral.

4. Device according to Claim 1, **characterized in that** it comprises first means for connection to a power socket (30) and second means for connection to an electrical equipment item (32) suitable for being connected to said socket.

5. Socket (20) for accessing an electrical network, **characterized in that** it comprises a device according to any one of Claims 1 to 4.

6. Equipment item comprising means for connection to an electrical network, **characterized in that** it comprises a device according to any one of Claims 1 to 4.

7. Power line data transmission system,
comprising at least one electrical network having a plurality of access sockets, suitable for cooperating with at least one equipment item comprising means for connection to said network,
at least one high-frequency data signal transmitting equipment item, and at least one high-frequency data signal receiving equipment item,
**characterized in that** each socket for access to said electrical network situated between said transmitting equipment item and said receiving equipment item comprises a device according to any of Claims 1 to 4.

FIGURE 1

FIGURE 2

FIGURE 3

FIGURE 4

FIGURE 5

FIGURE 6A

Vin    R         Vout

C

FIGURE 6B

R    L    G    C    Vs(f)

Ve(f)

dx

FIGURE 7

FIGURE 8

FIGURE 9

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0169812 A

- US 20030095036 A